(19) Europäisches Patentamt
European Patent Office
Office européen des brevets

(11) Veröffentlichungsnummer: **0 364 735 B1**

(12) **EUROPÄISCHE PATENTSCHRIFT**

(45) Veröffentlichungstag der Patentschrift: **01.06.94**

(51) Int. Cl.$^5$: **G03F 7/029**

(21) Anmeldenummer: **89117004.5**

(22) Anmeldetag: **14.09.89**

# (54) Photopolymerisierbares Gemisch und daraus hergestelltes Aufzeichnungsmaterial.

(30) Priorität: **21.09.88 DE 3832032**

(43) Veröffentlichungstag der Anmeldung:
**25.04.90 Patentblatt 90/17**

(45) Bekanntmachung des Hinweises auf die Patenterteilung:
**01.06.94 Patentblatt 94/22**

(84) Benannte Vertragsstaaten:
**DE FR GB IT NL**

(56) Entgegenhaltungen:
**EP-A- 0 211 615**
**EP-A- 0 234 430**
**EP-A- 0 243 784**
**EP-A- 0 272 215**
**EP-A- 0 277 915**
**DE-A- 2 704 368**
**US-A- 3 479 185**

(73) Patentinhaber: **HOECHST AKTIENGESELLSCHAFT**
**D-65926 Frankfurt(DE)**

(72) Erfinder: **Zertani, Rudolf, Dr.**
**Hans-Zöller-Strasse 111**
**D-6500 Mainz-Laubenheim(DE)**
Erfinder: **Mohr, Dieter, Dr.**
**Eubonner Strasse 8**
**D-6501 Budenheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services
(3.10/3.09/3.3.3)

## Beschreibung

Die Erfindung betrifft ein photopolymerisierbares Gemisch, das ein polymeres Bindemittel, eine polymerisierbare Verbindung, insbesondere einen Acryl- oder Alkacrylsäureester sowie eine Photoinitiatorkombination enthält.

Photopolymerisierbare Gemische, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten, sind bekannt. Derartige synergistisch wirkende Gemische sind z. B. in den US-A 3 759 807, 4 054 682 und 4 071 424 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129 214, angemeldet am 2.4.1974 unter der Nummer 49/36614, wird ein photopolymerisierbares Gemisch beschrieben, das als polymerisierbare Verbindung einen Tetra(meth)acrylsäureester eines N,N,N′,N′-Tetrahydroxyalkyl-alkylendiamins enthält. Die tetrafunktionelle Verbindung dient als Vernetzungsmittel.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z. B. Aminen, anstoßen kann (US-A 3 097 096). Diese Initiatorkombinationen werden jedoch im wesentlichen nur in wäßriger Lösung oder in Kombination mit wasserlöslichen Bindemitteln eingesetzt.

Initiatorkombinationen aus photoreduzierbaren Farbstoffen und anderen Reduktionsmitteln sind in den US-A 3 597 343 und 3 488 269 beschrieben. Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

In der JP-A 54/151 024 ist ein photopolymerisierbares Gemisch beschrieben, das eine Initiatorkombination aus einem Merocyaninfarbstoff und einem trihalogenmethylsubstituierten s-Triazin enthält und gegenüber sichtbarem Licht, z. B. einem Argonlaser, empfindlich ist. Die Empfindlichkeit dieser Gemische gegenüber sichtbarem Laserlicht ist jedoch für eine wirtschaftliche Nutzung nicht ausreichend.

In der älteren EP-A 0 287 817 werden photopolyiaerisierbare Gemische beschrieben, die (Meth)-acrylsäureester mit Urethangruppen, tertiären Aminogruppen und ggf. Harnstoffgruppen im Molekül, polymere Bindemittel und, als Photoinitiatoren, eine Kombination aus einem photoreduzierbaren Farbstoff, einer strahlungsempfindlichen Trihalogenmethylverbindung und einer Acridin-, Phenazin- oder Chinoxalinverbindung enthalten.

In der US-A 3 717 558 sind Metallocene von Elementen der Nebengruppen IIa bis VIIIa in Kombination mit einem weiteren Photoinitiator mit einer Carbonsäurechloridgruppe für den Einsatz in photopolymerisierbaren Aufzeichnungsmaterialien beschrieben. Diese Initiatorkombinationen sind sehr sauerstoff- und hydrolyseempfindlich und dadurch für die Herstellung von Druckplatten und Resistmaterialien weniger geeignet. Weitere Metallocene und deren Einsatz als Photoinitiatoren in photopolymerisierbaren Gemischen werden in den EP-A 119 162, 122 223 und 186 626 beschrieben. Hierbei handelt es sich um Titanocene mit guter Stabilität gegen Luft. Sie weisen eine spektrale Empfindlichkeit im Bereich vom UV-Licht bis zum sichtbaren Licht auf. In den üblichen Lösemitteln zur Beschichtung sind sie allerdings nur schwer oder gar nicht löslich. Ferner werden in den EP-A 242 330 und 269 573 photopolymerisierbare Gemische beschrieben, die eine Photoinitiatormischung, bestehend aus einem Titanocen und einem flüssigen Photoinitiator vom Typ eines Hydroxy- oder Aminoacetophenons enthalten. Auch bei diesen Materialien ist die erzielbare Lichtempfindlichkeit für eine schnelle Bebilderung mit einem energieschwachen und zugleich kostengünstigen Argonionenlaser nicht ausreichend.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich auszeichnen und daher insbesondere zur Laserstrahlaufzeichnung im sichtbaren Bereich geeignet sind.

Erfindungsgemäß wird ein photopolymerisierbares Gemisch vorgeschlagen, das als wesentliche Bestandteile

a) ein polymeres Bindemittel,
b) eine radikalisch polymerisierbare Verbindung mit mindestens einer polymerisierbaren Gruppe und
c) einen photoreduzierbaren Farbstoff als Photoinitiator

enthält.

Das erfindungsgemäße Gemisch ist dadurch gekennzeichnet, daß es ferner

d) eine durch Strahlung spaltbare Trihalogenmethylverbindung und

e) eine Metallocenverbindung als Photoinitiatoren enthält.

Die als Initiatorbestandteil einsetzbaren Metallocene sind als solche bekannt. Die meisten dieser Verbindungen sind auch als Photoinitiatoren bekannt, z. B. aus den US-A 3 717 558 und 4 707 432. Bevorzugt werden Metallocene von Elementen der IV. Nebengruppe des Periodensystems, insbesondere Verbindungen des Titans und Zirkons. Derartige Verbindungen sind in den EP-A 119 162, 122 223, 186 626, 242 330, 255 486, 256 981 und 269 573 beschrieben. Von den zahlreichen bekannten Metallocenen, insbesondere Titanocenen, werden Verbindungen der allgemeinen Formel I

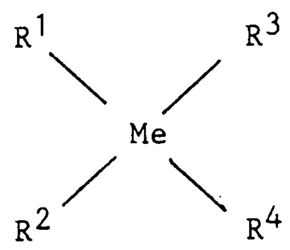 (I)

bevorzugt. In dieser Formel bedeuten

Me ein vierbindiges Metallatom, insbesondere Ti oder Zr,

$R^1$ und $R^2$ gleiche oder verschiedene Cyclopentadienylreste, die substituiert sein können, und

$R^3$ und $R^4$ gleiche oder verschiedene Phenylreste, die auch substituiert sein können.

Die Cyclopentadienylgruppen können insbesondere durch Alkylreste mit 1 bis 4 Kohlenstoffatomen, Chloratome, Phenyl- oder Cyclohexylreste substituiert oder durch Alkylengruppen miteinander verknüpft sein.

$R^3$ und $R^4$ sind bevorzugt Phenylgruppen, die in o-Stellung zur Bindung mindestens ein Fluoratom enthalten und im übrigen durch Halogenatome, wie F, Cl oder Br, Alkyl- oder Alkoxygruppen mit 1 bis 4 Kohlenstoffatomen oder eine ggf. veretherte oder veresterte Polyoxyalkylengruppe substituiert sein können. Die Polyoxyalkylengruppe hat im allgemeinen 1 bis 6 Oxyalkyleneinheiten und steht bevorzugt in 4-Stellung des Phenylrests und kann durch einen Alkyl- oder Acylrest mit 1 bis 18 Kohlenstoffatomen verethert bzw. verestert sein; sie ist insbesondere eine Polyoxyethylengruppe. Phenylreste, die mit 4 oder 5 Fluoratomen substituiert sind, werden besonders bevorzugt. Der Mengenanteil an Metallocenverbindung liegt im allgemeinen zwischen 0,01 und 10, vorzugsweise bei 0,05 bis 6 Gew.-%, bezogen auf die nichtflüchtigen Anteile des Gemischs.

Das erfindungsgemäße Gemisch enthält als weiteren Photoinitiatorbestandteil einen photoreduzierbaren Farbstoff. Geeignete Farbstoffe sind insbesondere Xanthen-, Benzoxanthen-, Benzothioxanthen, Thiazin-, Pyronin, Porphyrin- oder Acridinfarbstoffe.

Geeignete Xanthen- und Thiazinfarbstoffe sind z. B. in der älteren EP-A 0 287 817 beschrieben.

Geeignete Benzoxanthen- und Benzothioxanthenfarbstoffe sind in der DE-A 20 25 291 und der älteren EP-A 0 321 828 beschrieben.

Als Porphyrinfarbstoff ist z. B. Hämacoporphyrin und als Acridinfarbstoff z. B. Acriflaviniumchlorid-Hydrochlorid geeignet. Beispiele für Xanthenfarbstoffe sind Eosin B (C.I. Nr. 45 400), Eosin J (C.I. Nr. 45 380), Eosin alkohollöslich (C.I. 45 386), Cyanosin (C.I. Nr. 45 410), Bengalrosa, Erythrosin (C.I. Nr. 45 430), 2,3,7-Trihydroxy-9-phenyl-xanthen-6-on und Rhodamin 6 G (C.I. Nr. 45 160).

Beispiele für Thiazinfarbstoffe sind Thionin (C.I. Nr. 52 000), Azur A (C.I. Nr. 52 005) und Azur C (C.I. Nr. 52 002).

Beispiele für Pyroninfarbstoffe sind Pyronin B (C.I. Nr. 45 010) und Pyronin GY (C.I. Nr. 45 005). Die Menge des photoreduzierbaren Farbstoffs liegt im allgemeinen zwischen 0,01 und 10, vorzugsweise zwischen 0,05 und 4 Gew.-%, bezogen auf die nichtflüchtigen Anteile des Gemischs.

Zur Steigerung der Lichtempfindlichkeit enthalten die erfindungsgemäßen Gemische Verbindungen mit photolytisch spaltbaren Trihalogenmethylgruppen, die als radikalbildende Photoinitiatoren für photopolymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyltribrommethylsulfon, sind geeignet.

Diese Halogenverbindungen werden im allgemeinen in einer Menge von 0,01 bis 10, vorzugsweise von 0,05 bis 4 Gew.-%, bezogen auf die nichtflüchtigen Bestandteile des Gemischs, eingesetzt.

Die erfindungsgemäßen Gemische enthalten ggf. als weiteren Initiatorbestandteil eine Acridin-, Phenazin- oder Chinoxalinverbindung. Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Geeignete Vertreter dieser Verbindungsklasse sind in den genannten DE-C beschrieben. Beispiele sind in 9-Stellung substituierte Acridine, wie 9-Phenyl-, 9-p-Methoxyphenyl- oder 9-Acetylamino-acridin, oder Acridinderivate mit ankondensierten aromatischen Kernen, z. B. Benz(a)acridin. Als Phenazinderivat ist z. B. das 9,10-Dimethyl-benz(a)phenazin geeignet. Als Chinoxalinderivate kommen insbesondere die 2,3-Diphenylderivate in Betracht, die vorzugsweise in den beiden Phenylresten durch Methoxygruppen weiter substituiert sind. Im allgemeinen werden die Acridinderivate bevorzugt. Die Menge dieser Komponente im Gemisch liegt im Bereich von 0 bis 10 Gew.-%, vorzugsweise zwischen 0,05 und 5 Gew.-%.

Wenn eine weitere Empfindlichkeitssteigerung des Gemischs im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4′-disubstituierte Dibenzalacetone, z. B. 4-Diethylamino-4′-methoxy-dibenzalaceton, oder Cumarinderivate wie 3-Acetyl-7-diethylamino-, 3-Benzimidazolyl-7-diethylamino- oder Carbonyl-bis-(7-diethylaminocumarin). Die Menge dieser Verbindung liegt im Bereich von 0 bis 10, vorzugsweise von 0,05 bis 4 Gew.-%, bezogen auf die nichtflüchtigen Bestandteile des Gemischs.

Die Gesamtmenge an Polymerisationsinitiatoren liegt im allgemeinen bei 0,05 bis 20, vorzugsweise bei 0,1 bis 10 Gew.-%.

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Besonders bevorzugt werden polymerisierbare Verbindungen, die mindestens eine photooxydierbare und gegebenenfalls mindestens eine Urethangruppe im Molekül enthalten. Als photooxydierbare Gruppen kommen insbesondere Aminogruppen, Harnstoffgruppen, Thiogruppen, die auch Bestandteile heterocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel II

$$R_{(m-n)}Q\left[(-CH_2-\underset{R^6}{\overset{R^5}{\underset{|}{\overset{|}{C}}}}O)_a-CONH(X^1-NHCOO)_b-X^2(-OOC-\overset{R^7}{\overset{|}{C}}=CH_2)_c\right]_n \quad (II)$$

worin

Q

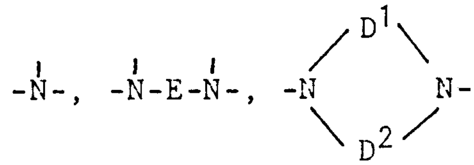

oder -S-

R eine Alkyl-, Hydroxyalkyl- oder Arylgruppe,

$R^5$ und $R^6$ jeweils ein Wasserstoffatom, eine Alkylgruppe oder Alkoxyalkylgruppe,

$R^7$ ein Wasserstoffatom, eine Methyl- oder Ethylgruppe,

$X^1$ eine gesättigte Kohlenwasserstoffgruppe mit 2 bis 12 Kohlenstoffatomen,

$X^2$ eine (c+1)-wertige gesättigte Kohlenwasserstoffgruppe, in der bis zu 5 Methylengruppen durch Sauerstoffatome ersetzt sein können,

$D^1$ und $D^2$ jeweils eine gesättigte Kohlenwasserstoffgruppe mit 1 bis 5 Kohlenstoffatomen,

E eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,

a 0 oder eine ganze Zahl von 1 bis 4,

b 0 oder 1,

c eine ganze Zahl von 1 bis 3,

m je nach Wertigkeit von Q 2, 3 oder 4 und

n eine ganze Zahl von 1 bis m

bedeutet, wobei alle Symbole gleicher Definition untereinander gleich oder verschieden sein können.

Die Verbindungen dieser Formel, ihre Herstellung und Verwendung sind ausführlich in der älteren EP-A 0 287 818 beschrieben.

Wenn in der Verbindung der allgemeinen Formel II mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatomen substituiert sein.

Wenn $R^5$ und $R^6$ Alkyl- oder Alkoxyalkylgruppen sind, können diese 1 bis 5 Kohlenstoffatome enthalten.

$R^7$ ist bevorzugt ein Wasserstoffatom oder eine Methylgruppe, insbesondere eine Methylgruppe.

$X^1$ ist bevorzugt ein geradkettiger oder verzweigter ali-phatischer oder cycloaliphatischer Rest mit vorzugsweise 4 bis 10 Kohlenstoffatomen.

$X^2$ hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. $X^2$ kann auch eine cycloaliphatische Gruppe mit 5 bis 10 Kohlenstotfatomen, insbesondere eine Cyclohexylengruppe sein.

$D^1$ und $D^2$ können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel II, die zwei Urethangruppen in jedem Rest (b = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen, N,N-Bis-hydroxyalkyl-piperazinen oder N,N,N′,N′-Tetra-hydroxyalkyl-alkylendiaminen, umgesetzt wird, wobei einzelne Hydroxyalkylgruppen durch Alkyl- oder Arylgruppen R ersetzt sein können. Wenn a = 0 ist, entsteht eine Harnstoffgruppierung.

Beispiele für die als Ausgangsstoffe verwendeten Hydroxyalkylamine sind Triethanolamin, N-Alkyl-N,N-di(hydroxyalkyl)amine, Diethanolamin, Tris-(2-hydroxypropyl)amin oder Tris-(2-hydroxybutyl)amin.

Beispiele für die als Ausgangsstoffe verwendeten Diisocyanate sind Hexamethylendiisocyanat, 2,2,4-Trimethylhexamethylendiisocyanat, 1,4-Cyclohexylendiisocyanat und 1,1,3-Trimethyl-3-isocyanatomethyl-5-isocyanatocyclohexan.

Als Hydroxygruppen enthaltende Ester werden insbesondere Hydroxyethylmethacrylat und Hydroxypropylmethacrylat (n oder iso) sowie die entsprechenden Acrylate verwendet.

Die polymerisierbaren Verbindungen der Formel II mit b = 0 werden dargestellt, indem die oben beschriebenen Hydroxyalkylaminoverbindungen mit Isocyanatgruppen enthaltenden Acryl- oder Alkylacrylsäureestern umgesetzt werden. Als Isocyanatgruppen enthaltender Ester wird insbesondere Isocyanatoethyl(meth)acrylat eingesetzt.

Weitere geeignete Verbindungen mit photooxydierbaren Gruppen sind Verbindungen der Formel III

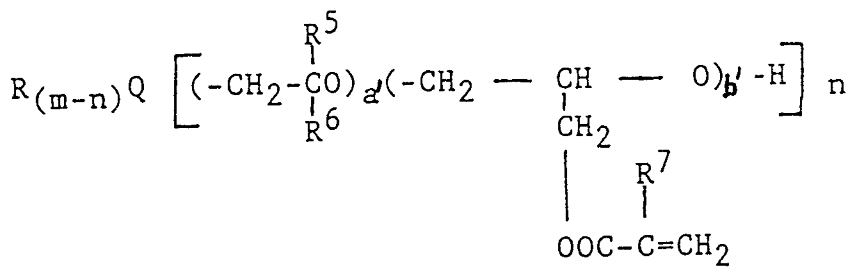

(III)

worin Q, R, $R^5$, $R^6$, $R^7$, a, m und n die oben angegebene Bedeutung haben und Q zusätzlich eine Gruppe

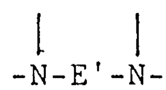

sein kann, worin E' eine Gruppe der Formel IV

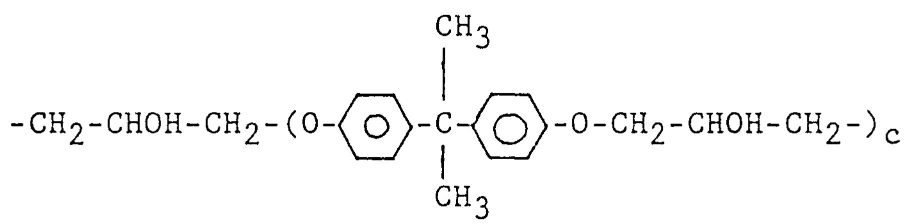

(IV),

ist, in der c die Bedeutung wie in Formel II hat.
a' und b' sind ganze Zahlen von 1 bis 4.

Die Herstellung der Verbindungen der Formel III erfolgt analog derjenigen der Formel II, wobei anstelle von Hydroxyalkyl(alk)acrylaten die entsprechenden (Alk)acrylsäureglycidylester eingesetzt werden.

Die Verbindungen dieser Formel, ihre Herstellung und Verwendung sind ausführlich in der älteren EP-A 316 706 beschrieben.

Weitere geeignete Verbindungen mit photooxydierbaren Gruppen sind Acryl- und Alkacrylsäureester der Formel V

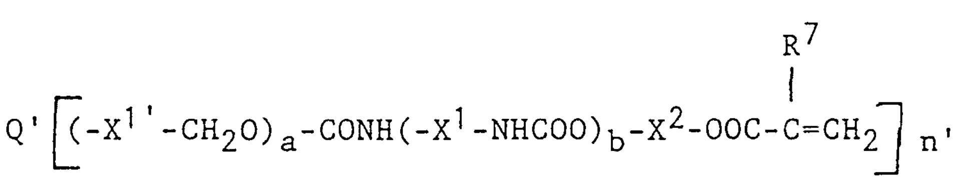

(V)

worin

Q'

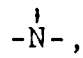

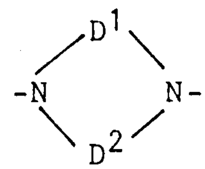

oder

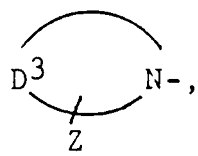

$X^{1'}$ $C_iH_{2i}$ oder

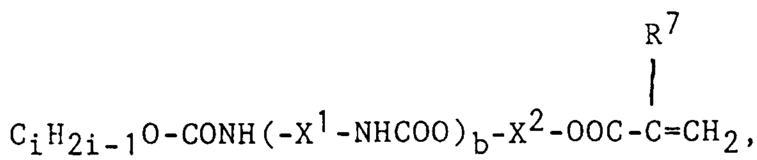

$D^3$ eine gesättigte Kohlenwasserstoffgruppe mit 4 bis 8 Kohlenstoffatomen, die mit dem Stickstoffatom einen 5- oder 6-gliedrigen Ring bildet,

Z ein Wasserstoffatom oder einen Rest der Formel

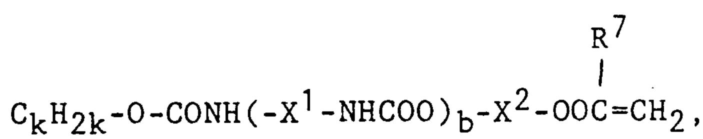

i und k ganze Zahlen von 1 bis 12,

n' je nach Wertigkeit von Q' 1, 2 oder 3

bedeutet, und $R^7$, $X^1$, $X^2$, $D^1$, $D^2$, a und b die bei Formel II angegebene Bedeutung haben, wobei alle Symbole gleicher Definition untereinander gleich oder verschieden sein können und wobei in mindestens einem Substituenten an der Gruppe Q a = O ist.

Von den Verbindungen der Formel V werden solche bevorzugt, die außer einer Harnstoffgruppe mindestens eine Urethangruppe enthalten. Als Harnstoffgruppen sollen Gruppen der Formel

$>N - CO - N<$

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht.

Das Symbol a ist in Formel V vorzugsweise 0 oder 1; i ist vorzugsweise eine Zahl von 2 bis 10.

Die polymerisierbaren Verbindungen der Formel V werden analog zu den Verbindungen der Formel II hergestellt.

Die Verbindungen der Formel V und ihre Herstellung sind ausführlich in der älteren EP-A 0 355 387 beschrieben.

Der Mengenanteil der photopolymerisierbaren Schicht an polymerisierbaren Verbindungen beträgt im allgemeinen etwa 10 bis 80, bevorzugt 20 bis 60 Gew.-%, bezogen auf die nichtflüchtigen Bestandteile.

Beispiele für verwendbare Bindemittel sind chloriertes Polyethylen, chloriertes Polypropylen, Poly-(meth)acrylsäurealkylester, bei denen die Alkylgruppe z. B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/ Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z. B. Nylon-6), Polyurethane, Methylcellulose, Ethylcellulose, Acetylcellulose, Polyvinylformal und Polyvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin sind geeignet Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, Acetaldehyd oder Aceton, mit Phenolen oder Copolymerisate der Hydroxystyrole. Schließlich lassen sich auch Copolymerisate des (Meth)-acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:
Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z. B. Novolake.

Die Menge des Bindemittels in der lichtempfindlichen Schicht beträgt im allgemeinen 20 bis 90, vorzugsweise 40 bis 80 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung. Die Lichtempfindlichkeit reicht von etwa 300 nm bis 700 nm und umspannt damit einen sehr breiten Bereich.

Durch die Kombination von photoreduzierbaren Farbstoffen mit photolytisch spaltbaren Halogenverbindungen und Metallocenen wird ein synergistisch wirkendes Initiatorsystem erhalten, dessen Aktivität, besonders im langwelligen Spektralbereich bei oder oberhalb 455 nm, in photopolymerisierbaren Gemischen den bekannten Photoinitiatorkombinationen überlegen ist. Besonders hohe Lichtempfindlichkeiten werden in Kombination mit polymerisierbaren Verbindungen erhalten, die photooxydierbare Gruppen enthalten. Durch den Ersatz von Acridin-, Phenazin- oder Chinoxalinverbindungen, die als Coinitiatoren in sonst gleichen photopolymerisierbaren Gemischen z. B. in der älteren deutschen Patentanmeldung P 37 10 281.8 beschrieben sind, durch die oben beschriebenen Metallocenverbindungen oder durch zusätzliche Verwendung der Metallocene neben den genannten Mehrkernheterocyclen werden Gemische mit wesentlich höherer Lichtempfindlichkeit erhalten. Auch gegenüber Gemischen mit bekannten, Metallocene enthaltenden Initiatorkombinationen zeigen die erfindungsgemäßen Gemische eine erheblich höhere Lichtempfindlichkeit.

Als Anwendungsmöglichkeiten für das erfindungsgemäße Material seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Als Schichtträger für das erfindungsgemäße Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen.

Durch die breite spektrale Empfindlichkeit des erfindungsgemäßen Aufzeichnungsmaterials können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Meallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Polyvinylalkohol, Polyphosphate, Zucker usw.. Solche Deckschichten haben im allgemeinen eine Dicke von 0,1 bis 10, vorzugsweise 1 bis 5 $\mu$m.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten.

Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

Beispiel 1 (Vergleichsbeispiel)

Als Schichtträger für Druckplatten wurde elektrochemisch aufgerauhtes und anodisiertes Aluminium mit einer Oxidschicht von 3 g/m$^2$ verwendet, das mit einer wäßrigen Lösung von Polyvinylphosphonsäure vorbehandelt worden war. Der Träger wurde mit einer Lösung der folgenden Zusammensetzung überzogen. Dabei wurden alle Operationen unter Rotlicht durchgeführt:
2,84 Gt einer 22,3 %igen Lösung eines Terpolymerisats aus Styrol, n-Hexylmethacrylat und Methacrylsäure (10:60:30) mit der Säurezahl 190 in Methylethylketon,
1,49 Gt Trimethylolethantriacrylat,
0,07 Gt Phenylmethansulfonylchlorid und
0,02 Gt Dicyclopentadienyltitandichlorid in
11 Gt Butanon und
11 Gt Butylacetat.

Das Auftragen erfolgte durch Aufschleudern in der Weise, daß ein Trockengewicht von 2,4 bis 2,8 g/m$^2$ erhalten wurde. Anschließend wurde die Platte zwei Minuten bei 100° C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 2,5 bis 4 g/m$^2$ erhalten. Die erhaltene Druckplatte wurde mittels einer 2 kW-Metallhalogenidlampe im Abstand von 110 cm unter einem 13-stufigen Belichtungskeil mit Dichteinkrementen von 0,15 belichtet, auf den zusätzlich ein Silberfilm mit gleichmäßiger Schwärzung (Dichte 1,4) und gleichmäßiger Absorption über den wirksamen Spektralbereich als Graufilter montiert wurde. Nach der Belichtung wurde die Platte eine Minute auf 100° C erwärmt. Anschließend wurde sie mit einem Entwickler folgender Zusammensetzung entwickelt:
120 Gt Natriummetasilikat • 9 $H_2O$,
2,13 Gt Strontiumchlorid,
1,2 Gt nichtionogenes Netzmittel (Kokosfettalkohol-Polyoxyethylenether mit ca. 8 Oxyethyleneinheiten) und
0,12 Gt Antischaummittel in
4000 Gt vollentsalztem Wasser.

Die Platte wurde mit fetter Druckfarbe eingefärbt. Es wurden die in Tabelle 1 angegebenen vollvernetzten Keilstufen erhalten.

Beispiel 2 (Vergleichsbeispiel)

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt der in Beispiel 1 angegebenen Terpolymerisatlösung
1,4 Gt Triethylenglykoldimethacrylat,
0,04 Gt Orasolblau (C.I. 50 315),
0,06 Gt Di-cyclopentadienyl-bis-pentafluorphenyl-titan in
11,0 Gt Butanon und
11,0 Gt Butylacetat.

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 1 angegebenen vollvernetzten Keilstufen erhalten.

Beispiel 3 (Vergleichsbeispiel)

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt einer 30 %igen Lösung eines Terpolymerisats aus Methylmethacrylat/Ethylacrylat/Methacrylsäure (60:25:15) in Butanon,

0,85 Gt Pentaerythrittriacrylat,
0,02 Gt Kristallviolett und
0,02 Gt Di-cyclopentadienyl-bis-pentafluorphenyl-titan in
11,0 Gt Butanon und
11,0 Gt Propylenglykolmonomethylether.

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 1 angegebenen vollvernetzten Keilstufen erhalten.

Beispiel 4

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt der in Beispiel 3 angegebenen Terpolymerisatlösung,
1,4 Gt Triethylenglykoldimethacrylat,
0,04 Gt Orasolblau (C.I. 50 315),
0,04 Gt Eosin alkohollöslich (C.I. 45 386),
0,03 Gt 2,4-Bis-trichlormethyl-6-(4-styrylphenyl)-s-triazin und
0,06 Gt Di-cyclopentadienyl-bis-pentafluorphenyl-titan in
11,0 Gt Butanon und
11,0 Gt Butylacetat.

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 1 angegebenen vollvernetzten Keilstufen erhalten.

Beispiel 5

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt der in Beispiel 3 angegebenen Terpolymerisatlösung,
0,85 Gt Pentaerythrittriacrylat,
0,02 Gt Kristallviolett,
0,04 Gt Eosin alkohollöslich (C.I. 45 386),
0,03 Gt 2,4-Bis-trichlormethyl-6-(4-styrylphenyl)-s-triazin und
0,02 Gt Di-cyclopentadienyl-bis-pentafluorphenyl-titan in
11,0 Gt Butanon und
11,0 Gt Propylenglykolmonomethylether.

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 1 angegebenen vollvernetzten Keilstufen erhalten.

Beispiel 6

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt der in Beispiel 1 angegebenen Terpolymerisatlösung,
1,4 Gt des Umsetzungsprodukts von 1 mol Triethanolamin mit 3 mol Isocyanatoethylmethacrylat,
0,04 Gt Orasolblau (C.I. 50 315),
0,04 Gt Eosin alkohollöslich (C.I. 45 386),
0,03 Gt 2,4-Bis-trichlormethyl-6-(4-styrylphenyl)-s-triazin und
0,06 Gt Di-cyclopentadienyl-bis-pentafluorphenyl-titan in
11,0 Gt Butanon und
11,0 Gt Butylacetat.

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 1 angegebenen

vollvernetzten Keilstufen erhalten.

Beispiel 7

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:

2,84 Gt der in Beispiel 3 angegebenen Terpolymerisatlösung,
1,4 Gt des Umsetzungsprodukts von 1 mol Triethanolamin mit 3 mol Isocyanatoethylmethacrylat,
0,02 Gt Kristallviolett,
0,04 Gt Eosin alkohollöslich (C.I. 45 386),
0,03 Gt 2,4-Bis-trichlormethyl-6-(4-styrylphenyl)-s-triazin und
0,06 Gt Di-cyclopentadienyl-bis-pentafluorphenyl-titan in
11,0 Gt Butanon und
11,0 Gt Propylenglykolmonomethylether.

Die Platte wurde dann wie in Beispiel 1 mit einer Polyvinylalkoholschicht überzogen und wie dort belichtet und entwickelt. Nach Einfärben mit fetter Druckfarbe wurden die in Tabelle 1 angegebenen vollvernetzten Keilstufen erhalten.

Tabelle 1

| Beispiel Nr. | Belichtung (Sekunden) | Graufilter D = 1.4 | Keilstufen |
|---|---|---|---|
| 1 (V) | 30 | nein | 4 - 5 |
| 2 (V) | 5 | nein | 5 - 6 |
| 3 (V) | 3 | nein | 10 |
| 4 | 1 | nein | * |
| 4 | 20 | ja | 7 |

Tabelle 1 (Fortsetzung)

| Beispiel Nr. | Belichtung (Sekunden) | Graufilter D = 1.4 | Keilstufen |
|---|---|---|---|
| 5 | 20 | ja | 10 |
| 6 | 20 | ja | 12 |
| 7 | 10 | ja | 11 |

* überbelichtet (> 13 Stufen)
V = Vergleichsbeispiel

Beispiele 8 bis 13 (Vergleichsbeispiele)

Auf den in Beispiel 1 angegebenen Schichtträger wurden unter gleichen Bedingungen wie dort Lösungen folgender Zusammensetzung so aufgeschleudert, daß jeweils ein Schichtgewicht von 2,5 g/m$^2$ erhalten wurde:

2,84 Gt der in Beispiel 1 angegebenen Terpolymerisatlösung,
1,49 Gt Monomeres gemäß Tabelle 2,
0,04 Gt Eosin alkohollöslich (C.I. 45 386),
0,03 Gt 2,4-Bis-trichlormethyl-6-(4-styrylphenyl)-s-triazin und
0,049 Gt 9-Phenylacridin in
22 Gt Propylenglykolmonomethylether.

Tabelle 2

| Eingesetzte Monomere: | |
|---|---|
| Beispiel Nr. | |
| 8 | Umsetzungsprodukt von 1 mol Triethanolamin mit 3 mol Isocyanatoethylmethacrylat, |
| 9 | Umsetzungsprodukt von 1 mol N,N'-Bis-β-hydroxyethyl-piperazin mit 2 mol Isocyanatoethylmethacrylat, |
| 10 | Umsetzungsprodukt von 1 mol Triethanolamin mit 3 mol Glycidylmethacrylat, |
| 11 | Umsetzungsprodukt von 1 mol 2,2,4-Trimethyl-hexamethylendiisocyanat mit 2 mol 2-Hydroxy-ethylmethacrylat, |
| 12 | Umsetzungsprodukt von 1 mol Hexamethylendiisocyanat mit 1 mol 2-Hydroxy-ethylmethacrylat und 0,33 mol Triethanolamin, |
| 13 | Trimethylolethantriacrylat |

Nach Auftragen einer Deckschicht aus Polyvinylalkohol wurden die Platten in gleicher Weise wie in Beispiel 1 belichtet und entwickelt. Um die Empfindlichkeit der Druckplatten im sichtbaren Licht zu testen, wurden auf den Belichtungskeil ein 3 mm starkes Kantenfilter der Firma Schott mit der Kantendurchlässigkeit von 455 nm und ein Silberfilm mit gleichmäßiger Schwärzung (Dichte 1,1) als Graufilter montiert. Es wurde die folgende Anzahl vollvernetzter Keilstufen erhalten:

Tabelle 3

| Beispiel Nr. | Belichtung (Sekunden) | Keilstufen |
|---|---|---|
| 8 | 15 | 1 |
| 9 | 15 | 2 |
| 10 | 15 | 2-3 |
| 11 | 20 | 1 |
| 12 | 15 | 2-3 |
| 13 | 15 | - * |

* Kein Bild

Beispiele 14 bis 19

Auf den in Beispiel 1 angegebenen Schichtträger wurden unter gleichen Bedingungen wie dort Lösungen folgender Zusammensetzung so aufgeschleudert, daß jeweils ein Schichtgewicht von 2,5 $g/m^2$ erhalten wurde:
2,84 Gt der in Beispiel 1 angegebenen Terpolymerisatlösung,
1,49 Gt Monomeres gemäß Tabelle 2,
0,04 Gt Eosin alkohollöslich (C.I. 45 386),
0,03 Gt 2,4-Bis-trichlormethyl-6-(4-styrylphenyl)-s-triazin und
0,01 Gt Dicyclopentadienyl-bis-pentafluorphenyl-titan in
22 Gt Propylenglykolmonomethylether.

Nach Auftragen einer Deckschicht aus Polyvinylalkohol wurden die Platten in gleicher Weise wie in Beispiel 1 15 Sekunden belichtet und dann entwickelt. Um die Empfindlichkeit der Druckplatten im sichtbaren Licht zu testen, wurden auf den Belichtungskeil ein 3 mm starkes Kantenfilter der Firma Schott mit der Kantendurchlässigkeit von 455 nm und - soweit angegeben - ein Silberfilm mit gleichmäßiger Schwärzung (Dichte 1,1) als Graufilter montiert. Es wurde die folgende Anzahl vollvernetzter Keilstufen erhalten:

Tabelle 4

| Beispiel Nr. | Monomer Nr. | Graufilter D = 1.1 | Keilstufen |
|---|---|---|---|
| 14 | 8 | ja | 8-9 |
| 15 | 9 | ja | 9 |
| 16 | 10 | ja | 7-9 |
| 17 | 11 | ja | 6-7 |
| 18 | 12 | ja | 7-9 |
| 19 | 13 | ja | - * |
| 19 | 13 | nein | 3-4 |

* Kein Bild

Beispiele 20 bis 26

Auf den in Beispiel 1 angegebenen Schichtträger wurden unter gleichen Bedingungen wie dort Lösungen folgender Zusammensetzung so aufgeschleudert, daß jeweils ein Schichtgewicht von 2,5 $g/m^2$ erhalten wurde:

2,84 Gt der in Beispiel 1 angegebenen Terpolymerisatlösung,
1,49 Gt Monomeres 8 gemäß Tabelle 2,
0,04 Gt Eosin alkohollöslich (C.I. 45 386),
0,03 Gt Halogenverbindung gemäß Tabelle 5,
0,01 Gt Dicyclopentadienyl-bis-pentafluorphenyl-titan in
22 Gt Propylenglykolmonomethylether.

Nach Auftragen einer Deckschicht aus Polyvinylalkohol wurden die Platten in gleicher Weise wie in Beispiel 1 15 Sekunden belichtet und dann entwickelt. Die Belichtung erfolgte unter einem Graufilter (D = 1,1) und einem Kantenfilter 455 nm. Es wurde die folgende Anzahl vollvernetzter Keilstufen erhalten:

Tabelle 5

| Beispiel Nr. | Halogenverbindung | Keilstufen |
|---|---|---|
| 20 | 2,4-Bis-trichlormethyl-6-(5-methoxy-naphth-1-yl)-s-triazin | 9 |
| 21 | 2,4-Bis-trichlormethyl-6-methyl-s-triazin | 9-10 |
| 22 | 2,4-Bis-trichlormethyl-6-phenyl-s-triazin | 9-10 |
| 23 | Phenyl-tribrommethyl-sulfon | 8 |

Tabelle 5 (Fortsetzung)

| Beispiel Nr. | Halogenverbindung | Keilstufen |
|---|---|---|
| 24 | 2,4,6-Tris-trichlor-methyl-s-triazin | 8-9 |
| 25 | 2,4-Bis-trichlormethyl-6-(biphenylyl)-s-triazin | 9 |
| 26 | 2-(p-Trichlormethyl-benzoylmethylen)-3-ethyl-benzthiazolin | 7-8 |

Beispiel 27 (Vergleichsbeispiel)

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt der in Beispiel 1 angegebenen Terpolymerisatlösung,
1,49 Gt Monomeres 8 gemäß Tabelle 2,
0,04 Gt Eosin alkohollöslich (C.I. 45 386),
0,01 Gt Dicyclopentadienyl-bis-pentafluorphenyl-titan in
22 Gt Propylenglykolmonomethylether.

Nach Auftragen einer Deckschicht aus Polyvinylalkohol wurde die Platte in gleicher Weise wie in Beispiel 1 15 Sekunden belichtet und dann entwickelt. Die Belichtung erfolgte unter einem Graufilter (D = 1,1) und einem Kantenfilter 455 nm. Es wurden 6 bis 7 vollvernetzte Keilstufen erhalten:

Beispiel 28 (Vergleichsbeispiel)

Auf den in Beispiel 1 angegebenen Schichtträger wurde unter gleichen Bedingungen wie dort eine Lösung folgender Zusammensetzung so aufgeschleudert, daß ein Schichtgewicht von 2,5 g/m$^2$ erhalten wurde:
2,84 Gt der in Beispiel 1 angegebenen Terpolymerisatlösung,
1,49 Gt Monomeres 8 gemäß Tabelle 2,
0,01 Gt Dicyclopentadienyl-bis-pentafluorphenyl-titan in
22 Gt Propylenglykolmonomethylether.

Nach Auftragen einer Deckschicht aus Polyvinylalkohol wurde die Platte in gleicher Weise wie in Beispiel 1 15 Sekunden belichtet und dann entwickelt. Die Belichtung erfolgte unter einem Graufilter (D = 1,1) und einem Kantenfilter 455 nm. Es wurden 6 bis 7 vollvernetzte Keilstufen erhalten:

Beispiel 29

Die Beschichtungslösung aus Beispiel 14 wurde auf eine biaxial verstreckte 35 µm dicke Polyethylenterephthalatfolie so aufgeschleudert, daß nach dem Trocknen ein Schichtgewicht von 15 g/m$^2$ erhalten wurde. Die Schicht wurde drei Minuten bei 100 °C im Umlufttrockenschrank nachgetrocknet. Anschließend wurde die Schicht bei 115 °C mit 1,5 m/min auf einen gereinigten Träger laminiert, der aus einer Isolierstoffplatte mit 35 µm Kupferauflage bestand.

Die Schicht wurde mittels einer 5 kW-Metallhalogenidlampe (140 cm Abstand) unter einem Kantenfilter 455 nm, wie im Beispiel 8 beschrieben, mit einem Stufenkeil als Vorlage 30 Sekunden belichtet und nach dem Abziehen der Folie mit 0,8 %iger Sodalösung in einem Sprühprozessor 20 Sekunden entwickelt. Es wurden 6 vollvernetzte Keilstufen erhalten. Die vernetzte Schicht war gegen die in der Leiterplattentechnik

übliche Eisen-III-chlorid-Lösung resistent.

Beispiel 30

Auf den in Beispiel 1 angegebenen Schichtträger wurde unter gleichen Bedingungen wie dort eine Lösung folgender Zusammensetzung so aufgeschleudert, daß ein Schichtgewicht von 2,5 $g/m^2$ erhalten wurde:

2,84 Gt der in Beispiel 1 angegebenen Terpolymerisatlösung,
1,49 Gt Monomeres 8 gemäß Tabelle 2,
0,04 Gt Eosin alkohollöslich (C.I. 45 386),
0,03 Gt 2,4-Bis-trichlormethyl-6-(4-styrylphenyl)-s-triazin und
0,01 Gt Dicyclopentadienyl-bis-pentafluorphenyl-zirkon in
11,0 Gt Butanon und
11,0 Gt Butylacetat

Nach Auftragen einer Deckschicht aus Polyvinylalkohol wurde die Platte in gleicher Weise wie in Beispiel 1 15 Sekunden belichtet und dann entwickelt. Die Belichtung erfolgte unter einem Graufilter (D = 1,1) und einem Kantenfilter 455 nm. Es wurden 6 bis 7 vollvernetzte Keilstufen erhalten.

## Patentansprüche

**1.** Photopolymerisierbares Gemisch, das als wesentliche Bestandteile
a) ein polymeres Bindemittel,
b) eine radikalisch polymerisierbare Verbindung mit mindestens einer polymerisierbaren Gruppe und
c) einen photoreduzierbaren Farbstoff als Photoinitiator
enthält und ferner als Photoinitiatoren
d) eine durch Strahlung spaltbare Trihalogenmethylverbindung und
e) eine Metallocenverbindung.

**2.** Gemisch nach Anspruch 1, dadurch gekennzeichnet, daß die Metallocenverbindung aus einem zentralen Metallatom und vier Liganden mit aromatischem Elektronensystem besteht.

**3.** Gemisch nach Anspruch 2, dadurch gekennzeichnet, daß das Metallatom ein Atom der IV. Nebengruppe des Periodensystems ist.

**4.** Gemisch nach Anspruch 3, dadurch gekennzeichnet, daß das Metallatom ein Titan- oder Zirkonatom ist.

**5.** Gemisch nach Anspruch 2, dadurch gekennzeichnet, daß zwei der Liganden ggf. substituierte Cyclopentadienylreste sind.

**6.** Gemisch nach Anspruch 2 oder 5, dadurch gekennzeichnet, daß zwei der Liganden Phenylreste sind, die ggf. durch Halogenatome oder Polyoxyalkylenreste substituiert sind.

**7.** Gemisch nach Anspruch 6, dadurch gekennzeichnet, daß die Halogenatome Fluoratome sind.

**8.** Gemisch nach Anspruch 1, dadurch gekennzeichnet, daß die radikalisch polymerisierbare Verbindung ein Acryl- oder Alkacrylsäureester mit mindestens einer bei Belichtung in Gegenwart des photoreduzierbaren Farbstoffs photooxydierbaren Gruppe ist.

**9.** Gemisch nach Anspruch 8, dadurch gekennzeichnet, daß die photooxydierbare Gruppe eine Amino-, Harnstoff-, Thio- oder Enolgruppe ist.

**10.** Gemisch nach Anspruch 1, dadurch gekennzeichnet, daß der photoreduzierbare Farbstoff ein Xanthen-, Thiazin-, Pyronin-, Porphyrin- oder Acridinfarbstoff ist.

**11.** Gemisch nach Anspruch 1, dadurch gekennzeichnet, daß die durch Strahlung spaltbare Trihalogenmethylverbindung ein s-Triazin, das durch mindestens eine Trihalogenmethylgruppe und ggf. eine weitere Gruppe substituiert ist, oder ein Aryltrihalogenmethylsulfon ist.

**12.** Gemisch nach Anspruch 1, dadurch gekennzeichnet, daß es als Photoinitiator ferner eine als Photoinitiator wirksame Acridin-, Phenazin- oder Chinoxalinverbindung enthält.

**13.** Gemisch nach Anspruch 1, dadurch gekennzeichnet, daß das Bindemittel wasserunlöslich und in wäßrigalkalischen Lösungen löslich ist.

**14.** Gemisch nach Anspruch 1, dadurch gekennzeichnet, daß es 10 bis 80 Gew.-% polymerisierbare Verbindung, 20 bis 90 Gew.-% polymeres Bindemittel und 0,05 bis 20 Gew.-%, bezogen auf die nichtflüchtigen Bestandteile des Gemischs, an strahlungsaktivierbaren Polymerisationsinitiatoren enthält.

**15.** Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

**16.** Aufzeichnungsmaterial nach Anspruch 15, dadurch gekennzeichnet, daß es auf der photopolymerisierbaren Schicht eine weitere, transparente, für Luftsauerstoff wenig durchlässige Schicht enthält, die in einer Entwicklerflüssigkeit für die photopolymerisierbare Schicht löslich ist.

## Claims

**1.** Photopolymerizable mixture which contains, as the essential constituents,
a) a polymeric binder,
b) a free-radically polymerizable compound having at least one polymerizable group and
c) a photoreducible dye as a photoinitiator,
and which additionally contains, as photoinitiators,
d) a trihalomethyl compound which can be cleaved by radiation and
e) a metallocene compound.

**2.** A mixture as claimed in claim 1, wherein the metallocene compound comprises a central metal atom and four ligands having aromatic electron systems.

**3.** A mixture as claimed in claim 2, wherein the metal atom is an atom of Subgroup IV of the Periodic Table.

**4.** A mixture as claimed in claim 3, wherein the metal atom is a titanium or zirconium atom.

**5.** A mixture as claimed in claim 2, wherein two of the ligands are substituted cyclopentadienyl radicals.

**6.** A mixture as claimed in claim 2 or 5, wherein two of the ligands are phenyl radicals which may be substituted by halogen atoms or by polyoxyalkylene radicals.

**7.** A mixture as claimed in claim 6, wherein the halogen atoms are fluorine atoms.

**8.** A mixture as claimed in claim 1, wherein the free-radically polymerizable compound is an acrylic or alkacrylic ester having at least one group which is photooxidizable upon exposure in the presence of the photoreducible dye.

**9.** A mixture as claimed in claim 8, wherein the photooxidizable group is an amino, urea, thio or enol group.

**10.** A mixture as claimed in claim 1, wherein the photoreducible dye is a xanthene, thiazine, pyronine, porphyrine or acridine dye.

**11.** A mixture as claimed in claim 1, wherein the trihalomethyl compound which can be cleaved by radiation is an s-triazine which is substituted by at least one trihalomethyl group and optionally a further group or is an aryl trihalomethylsulfone.

12. A mixture as claimed in claim 1, wherein an acridine, phenazine or quinoxaline compound which has a photoinitiating action is additionally present as a photoinitiator.

13. A mixture as claimed in claim 1, wherein the binder is insoluble in water and soluble in aqueous-alkaline solutions.

14. A mixture as claimed in claim 1, which contains from 10 to 80 % by weight of polymerizable compound, from 20 to 90 % by weight of polymeric binder and from 0.05 to 20 % by weight, based on the non-volatile constituents of the mixture, of radiation-activatable polymerization initiators.

15. Photopolymerizable recording material having a support material and a photopolymerizable layer, wherein the photopolymerizable layer comprises a mixture as claimed in claim 1.

16. A recording material as claimed in claim 15, wherein the photopolymerizable layer is provided with a further transparent layer which shows hardly any permeability to atmospheric oxygen and is soluble in a developer liquid used for the photopolymerizable layer.

**Revendications**

1. Composition photopolymérisable, contenant en tant que composants essentiels:
   a) un liant polymère,
   b) un composé polymérisable par polymérisation radicalaire, comportant au moins un groupe polymérisable, et
   c) un colorant photoréductible, en tant que photoinitiateur,
   
   et en outre, en tant que photo-initiateurs,
   d) un composé trihalogénométhyle dissociable par irradiation, et
   e) un composé métallocène.

2. Composition selon la revendication 1, caractérisée en ce que le composé métallocène consiste en un atome métallique central et quatre ligands à système électronique aromatique.

3. Composition selon la revendication 2, caractérisée en ce que l'atome métallique est un atome du sous-groupe IV du tableau périodique.

4. Composition selon la revendication 3, caractérisée en ce que l'atome métallique est un atome de titane ou de zirconium.

5. Composition selon la revendication 2, caractérisée en ce que deux des ligands sont des radicaux cyclopentadiényle éventuellement substitués.

6. Composition selon la revendication 2 ou 5, caractérisée en ce que deux des ligands sont des restes phényle qui sont éventuellement substitués par des atomes d'halogène ou des radicaux polyoxyalkylène.

7. Composition selon la revendication 6, caractérisée en ce que les atomes d'halogène sont des atomes de fluor.

8. Composition selon la revendication 1, caractérisée en ce que le composé polymérisable par polymérisation radicalaire est un ester acrylique ou alkacrylique comportant au moins un groupe photooxydable lors d'insolation en présence du colorant photoréductible.

9. Composition selon la revendication 8, caractérisée en ce que le groupe photooxydable est un groupe amino, urée, thio ou énol.

10. Composition selon la revendication 1, caractérisée en ce que le colorant photoréductible est un colorant xanthène, thiazine, pyronine, porphyrine ou acridine.

**11.** Composition selon la revendication 1, caractérisée en ce que le composé trihalogénométhyle dissociable par irradiation est une triazine-s qui est substituée par au moins un groupe trihalogénométhyle et éventuellement un autre groupe, ou une aryltrihalogénométhylsulfone.

**12.** Composition selon la revendication 1, caractérisée en ce qu'elle contient en outre, en tant que photoinitiateur, un composé acridine, phénazine ou quinoxaline actif en tant que photo-initiateur.

**13.** Composition selon la revendication 1, caractérisée en ce que le liant est insoluble dans l'eau et soluble dans des solutions aqueuses-alcalines.

**14.** Composition selon la revendication 1, caractérisée en ce qu'elle contient 10 à 80 % en poids de composé polymérisable, 20 à 90 % en poids de liant polymère et 0,05 à 20 % en poids, par rapport au composants non volatils du mélange, d'initiateurs de polymérisation activables par irradiation.

**15.** Matériau de reprographie photopolymérisable, comportant un support de couche et une couche photopolymérisable, caractérisé en ce que la couche photopolymérisable consiste en une composition selon la revendication 1.

**16.** Matériau de reprographie selon la revendication 15, caractérisé en ce qu'il contient, sur la couche photopolymérisable, une autre couche transparente, peu perméable à l'oxygène de l'air, qui est soluble dans un liquide de développement pour la couche photopolymérisable.